# EUROPÄISCHE PATENTANMELDUNG

(11) **EP 4 546 408 A1**
(43) Veröffentlichungstag der Anmeldung: **30.04.2025**
(21) Anmeldenummer: 23206469.1
(22) Anmeldetag: 27.10.2023
(51) Int. Cl.: H01L 23/00, H01L 23/498, H01L 25/07

(54) **HALBLEITERANORDNUNG MIT EINEM ERSTEN HALBLEITERELEMENT**

(71) Anmelder: Siemens Aktiengesellschaft, 80333 München (DE)
(72) Erfinder: Höhne, Silvio, 91301 Forchheim (DE); Käsbauer, Michael, 90453 Nürnberg (DE); Maier, Lukas, 91077 Neunkirchen am Brand (DE)
(74) Vertreter: Siemens Patent Attorneys

(57) **Zusammenfassung**

Die Erfindung betrifft ein Halbleiteranordnung (2) mit einem ersten Halbleiterelement (4), einem ersten Substrat (6), einem zweiten Substrat (20) und zumindest einem Verdrahtungselement (26). Um eine verbesserte Zuverlässigkeit zu erreichen, wird vorgeschlagen, dass das erste Substrat (6) eine erste Substratmetallisierung (14) mit voneinander elektrisch isoliert angeordneten Leitungsabschnitten (12, 16) aufweist, wobei das erste Halbleiterelement (4) und das zweite Substrat (20), insbesondere stoffschlüssig, mit einem ersten Leitungsabschnitt (12) der ersten Substratmetallisierung (14) verbunden sind, wobei das zweite Substrat (20) auf einer dem ersten Substrat (6) abgewandten Seite eine zweite Substratmetallisierung (22) aufweist, welche über eine zweite dielektrische Materiallage (24) elektrisch isoliert vom ersten Leitungsabschnitt (12) der ersten Substratmetallisierung (14) angeordnet ist, wobei das erste Halbleiterelement (4) auf einer dem ersten Substrat (6) abgewandten Seite eine Kontaktfläche (8) aufweist, wobei die Kontaktfläche (8) mit zumindest einem Verdrahtungselement (26) verbunden ist, wobei das zumindest eine Verdrahtungselement (26) einen ersten Verbindungsabschnitt (28), welcher die Kontaktfläche (8) mit einem vom dem ersten Leitungsabschnitt (12) elektrisch isoliert angeordneten zweiten Leitungsabschnitt (16) der ersten Substratmetallisierung (14) verbindet, und einen zweiten Verbindungsabschnitt (30), welcher die Kontaktfläche (8) mit der zweiten Substratmetallisierung (22) des zweiten Substrats (20) verbindet, aufweist.

## Beschreibung

Die Erfindung betrifft eine Halbleiteranordnung mit einem ersten Halbleiterelement, einem ersten Substrat, einem zweiten Substrat und zumindest einem Verdrahtungselement.

Ferner betrifft die Erfindung einen Stromrichter mit mindestens einer derartigen Halbleiteranordnung.

Darüber hinaus betrifft die Erfindung ein Verfahren zur Herstellung einer Halbleiteranordnung mit einem ersten Halbleiterelement, einem ersten Substrat, einem zweiten Substrat und zumindest einem Verdrahtungselement.

Eine derartige Halbleiteranordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden. Transistoren sind beispielsweise als Insulated-Gate-BipolarTransistoren (IGBTs), Feldeffekttransistoren oder Bipolartransistoren ausgeführt. Die Halbleiterelemente einer Halbleiteranordnung sind üblicherweise über Verdrahtungselemente auf einem Substrat kontaktiert. Derartige Verdrahtungselemente können unter anderem Bonddrähte und/oder Bondbänder umfassen. Insbesondere Lastkontakte eines Halbleiterelements, unter anderem ein Emitter-Kontakt eines IGBTs, sind üblicherweise mit einer Mehrzahl von Verdrahtungselementen auf dem Substrat kontaktiert.

Die Offenlegungsschrift EP 4 128 337 A1 beschreibt ein Leistungsmodul mit mindestens zwei Leistungseinheiten, welche jeweils mindestens einen Leistungshalbleiter und ein Substrat umfassen. Um die erforderliche Fläche des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Die wissenschaftliche Veröffentlichung "Electro-thermomechanical analyses on silver sintered IGBT-module reliability in power cycling", R. Dudek et al.,2015 16th International Conference on Thermal, Mechanical and Multi-Physics Simulation and Experiments in Microelectronics and Microsystems, 2015 beschreibt neue Anforderungen an die thermomechanische Auslegung von Sintersilberverbindungen. Im Mittelpunkt stehen neue Anforderungen an die thermomechanische Auslegung von Silber-Sinterverbindungen.

Während des Betriebes der Halbleiterelemente können sich Verdrahtungselemente vom Lastkontakt ablösen, was zu einem Ausfall der Halbleiteranordnung führt. Eine robustere Verdrahtung führt zu einer verbesserten Zuverlässigkeit der Halbleiteranordnung.

Vor diesem Hintergrund besteht die Aufgabe der vorliegenden Erfindung darin, eine Halbleiteranordnung anzugeben, welche eine verbesserte Zuverlässigkeit aufweist.

Die Aufgabe wird erfindungsgemäß gelöst durch eine Halbleiteranordnung mit einem ersten Halbleiterelement, einem ersten Substrat, einem zweiten Substrat und zumindest einem Verdrahtungselement, wobei das erste Substrat eine erste Substratmetallisierung mit voneinander elektrisch isoliert angeordneten Leitungsabschnitten aufweist, wobei das erste Halbleiterelement und das zweite Substrat, insbesondere stoffschlüssig, mit einem ersten Leitungsabschnitt der ersten Substratmetallisierung verbunden sind, wobei das zweite Substrat auf einer dem ersten Substrat abgewandten Seite eine zweite Substratmetallisierung aufweist, welche über eine zweite dielektrische Materiallage elektrisch isoliert vom ersten Leitungsabschnitt der ersten Substratmetallisierung angeordnet ist, wobei das erste Halbleiterelement auf einer dem ersten Substrat abgewandten Seite eine Kontaktfläche aufweist, wobei die Kontaktfläche mit zumindest einem Verdrahtungselement verbunden ist, wobei das zumindest eine Verdrahtungselement einen ersten Verbindungsabschnitt, welcher die Kontaktfläche mit einem vom dem ersten Leitungsabschnitt elektrisch isoliert angeordneten zweiten Leitungsabschnitt der ersten Substratmetallisierung verbindet, und einen zweiten Verbindungsabschnitt, welcher die Kontaktfläche mit der zweiten Substratmetallisierung des zweiten Substrats verbindet, aufweist.

Ferner wird die Aufgabe erfindungsgemäß gelöst durch einen Stromrichter mit mindestens einer derartigen Halbleiteranordnung.

Darüber hinaus wird die Aufgabe erfindungsgemäß gelöst durch ein Verfahren zur Herstellung einer Halbleiteranordnung mit einem ersten Halbleiterelement, einem ersten Substrat, einem zweiten Substrat und zumindest einem Verdrahtungselement, wobei das erste Substrat eine erste Substratmetallisierung mit voneinander elektrisch isoliert angeordneten Leitungsabschnitten aufweist, wobei das erste Halbleiterelement und das zweite Substrat, insbesondere stoffschlüssig, mit einem ersten Leitungsabschnitt der ersten Substratmetallisierung verbunden werden, wobei das zweite Substrat auf einer dem ersten Substrat abgewandten Seite eine zweite Substratmetallisierung aufweist, welche über eine zweite dielektrische Materiallage elektrisch isoliert vom ersten Leitungsabschnitt der ersten Substratmetallisierung angeordnet ist, wobei das erste Halbleiterelement auf einer dem ersten Substrat abgewandten Seite eine Kontaktfläche aufweist, wobei die Kontaktfläche mit zumindest einem Verdrahtungselement verbunden wird, wobei das zumindest eine Verdrahtungselement einen ersten Verbindungsabschnitt aufweist, über welchen die Kontaktfläche mit einem vom dem ersten Leitungsabschnitt elektrisch isoliert angeordneten zweiten Leitungsabschnitt der ersten Substratmetallisierung verbunden wird und einen zweiten Verbindungsabschnitt aufweist, über welchen die Kontaktfläche mit der zweiten Substratmetallisierung des zweiten Substrats verbunden wird.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde, die Zuverlässigkeit einer Halbleiteranordnung dadurch zu verbessern, dass die Wahrscheinlichkeit für einen Ausfall während des Betriebes der Halbleiteranordnung durch von einem ersten Halbleiterelement abgelöste Verdrahtungselemente signifikant verringert wird. Eine derartige Halbleiteranordnung weist ein erstes Substrat mit einer ersten Substratmetallisierung auf. Das erste Substrat kann unter anderem als ein DCB (Direct Copper Bonded) Substrat, ausgeführt sein. Die erste Substratmetallisierung ist strukturiert ausgeführt, das heißt sie weist voneinander elektrisch isoliert angeordnete Leitungsabschnitte auf. Das erste Halbleiterelement ist, insbesondere stoffschlüssig, mit einem ersten Leitungsabschnitt der ersten Substratmetallisierung verbunden. Die stoffschlüssige Verbindung wird beispielsweise durch Löten, Sintern oder Adhäsion hergestellt. Ferner weist das Halbleiterelement auf einer dem ersten Substrat abgewandten Seite eine Kontaktfläche auf, welche über zumindest ein Verdrahtungselement mit dem ersten Substrat verbunden ist. Beispielsweise ist das erste Halbleiterelement als IGBT ausgeführt, der kollektor-seitig auf den ersten Leitungsabschnitt der ersten Substratmetallisierung gelötet oder gesintert ist, während er emitterseitig über das zumindest eine Verdrahtungselement mit dem Substrat verbunden ist.

Das zumindest eine Verdrahtungselement ist beispielsweise als Bonddraht oder Bondband ausgeführt, wobei insbesondere durch Ultraschall-Bondverbindungen die Verbindung zwischen dem Substrat und der Kontaktfläche des Halbleiterelements herstellbar ist. Das zumindest eine Verdrahtungselement umfasst einen ersten Verbindungsabschnitt, der eine Verbindung der Kontaktfläche mit einem zweiten Leitungsabschnitt der ersten Substratmetallisierung herstellt. Fließt Strom, insbesondere Laststrom, durch das zumindest eine Verdrahtungselement, wirkt eine Scherkraft auf Verbindungen, insbesondere Ultraschall-Bondverbindungen, zwischen der Kontaktfläche des ersten Halbleiterelements und dem Verdrahtungselement.

Um einer derartigen Scherkraft entgegenzuwirken, umfasst das zumindest eine Verdrahtungselement einen zweiten Verbindungsabschnitt, der die Kontaktfläche mit einem zweiten Substrat verbindet, welches, insbesondere stoffschlüssig, mit dem ersten Leitungsabschnitt der ersten Substratmetallisierung verbunden ist. Das zweite Substrat weist auf einer dem ersten Substrat abgewandten Seite eine zweite Substratmetallisierung auf, mit welcher der zweite Verbindungsabschnitt des Verdrahtungselements verbunden ist, wobei die zweite Substratmetallisierung über eine zweite dielektrische Materiallage elektrisch isoliert von dem ersten Leitungsabschnitt der ersten Substratmetallisierung angeordnet ist. Die zweite dielektrische Materiallage kann unter anderem einen keramischen Werkstoff, insbesondere Aluminiumnitrid oder Aluminiumoxid, oder einen organischen Werkstoff, insbesondere ein Polymer, enthalten.

Somit weisen der erste Verbindungsabschnitt und der zweite Verbindungsabschnitt während eines Betriebes der Halbleiteranordnung einen unsymmetrischen Stromfluss auf, wobei ein Strom von der Halbleiteranordnung zumindest überwiegend, insbesondere im Wesentlichen ausschließlich, über den ersten Verbindungsabschnitt des zumindest einen Verdrahtungselements fließt. Durch die zusätzliche Verbindung des zumindest einen Verdrahtungselements über den zweiten Verbindungsabschnitt mit der zweiten Substratmetallisierung des zweiten Substrats, was auch "Überbonden" genannt wird, wirkt eine Gegenkraft der Scherkraft entgegen, sodass die Verbindung des zumindest einen Verdrahtungselements mit der Kontaktfläche, insbesondere unter Last, robuster ist, was sich positiv auf die Zuverlässigkeit der Halbleiteranordnung auswirkt und dessen Lebensdauer verlängert. Durch die zweite dielektrische Materiallage, welche die zweite Substratmetallisierung des zweiten Substrats von der ersten Substratmetallisierung des ersten Substrats elektrisch isoliert, wird die erste Substratmetallisierung des ersten Substrats, insbesondere im Vergleich zu einer Bondinsel, in ihren elektrischen Eigenschaften nicht merklich beeinflusst, sodass beispielsweise ein Strom, insbesondere Laststrom, des ersten Halbleiterelements im Wesentlichen ungehindert fließen kann, was sich ebenfalls positiv auf die Zuverlässigkeit der Halbleiteranordnung auswirkt.

Eine weitere Ausführungsform sieht vor, dass das zweite Substrat derartig auf dem ersten Leitungsabschnitt des ersten Substrats angeordnet ist, dass während eines Betriebes der Halbleiteranordnung ein Strom im ersten Leitungsabschnitt des ersten Substrats zumindest teilweise unterhalb des zweiten Substrats fließt. Somit steht für den Stromfluss mehr Querschnittsfläche zur Verfügung, was sich positiv auf die Zuverlässigkeit der Halbleiteranordnung auswirkt. Ferner wird durch eine derartige Anordnung Fläche eingespart.

Eine weitere Ausführungsform sieht vor, dass der unterhalb des zweiten Substrats fließende Strom ein Laststrom des ersten Halbleiterelements ist. Insbesondere für Lastströme ist eine ausreichend große Querschnittsfläche des Leiters ein wichtiger Faktor, um geringe Serienwiderstände zu erzielen, sodass Halbleiterelemente gleichmäßig ausgesteuert werden, was zu einer verbesserten Zuverlässigkeit der Halbleiteranordnung führt.

Eine weitere Ausführungsform sieht vor, dass das zweite Substrat flächig auf dem ersten Leitungsabschnitt der ersten Substratmetallisierung aufliegt. Insbesondere ist das zweite Substrat flächig mit dem ersten Leitungsabschnitt der ersten Substratmetallisierung verbunden. Eine derartige flächige Verbindung ist robust, was sich positiv auf die Zuverlässigkeit der Halbleiteranordnung auswirkt.

Eine weitere Ausführungsform sieht vor, dass sich die erste dielektrische Materiallage des ersten Substrats von der zweiten dielektrischen Materiallage des zweiten Substrats, insbesondere hinsichtlich ihrer elektrischen Isolation und/oder thermischen Leitfähigkeit, unterscheidet. Beispielsweise sind die elektrische Isolation und/oder die thermische Leitfähigkeit der ersten dielektrischen Materiallage größer als die der zweiten dielektrischen Materiallage. Insbesondere enthält die erste dielektrische Materiallage einen keramischen Werkstoff, während die zweite dielektrische Materiallage einen organischen Werkstoff enthält. Durch die Verwendung günstigerer Werkstoffe können Kosten eingespart werden.

Eine weitere Ausführungsform sieht vor, dass die erste dielektrische Materiallage des ersten Substrats eine erste Stärke und die zweite dielektrische Materiallage des zweiten Substrats eine zweite Stärke aufweist, wobei die zweite Stärke kleiner als die erste Stärke ist. Durch ein dünnes zweites Substrat wird der Scherkraft optimal entgegengewirkt, was sich positiv auf die Zuverlässigkeit der Halbleiteranordnung auswirkt.

Eine weitere Ausführungsform sieht vor, dass die zweite Substratmetallisierung des zweiten Substrats leerlaufend angeordnet ist. Eine leerlaufende Anordnung der zweiten Substratmetallisierung bedeutet, dass diese neben dem zumindest einen Verdrahtungselement mit keiner weiteren Komponente elektrisch leitend verbunden ist. Auf diese Weise wird, insbesondere unter Last, eine optimale Robustheit der Verbindungen des zumindest einen Verdrahtungselements mit der Kontaktfläche erzielt.

Eine weitere Ausführungsform sieht vor, dass der erste Verbindungsabschnitt und der zweite Verbindungsabschnitt des jeweiligen Verdrahtungselements im Wesentlichen symmetrisch bezüglich einer Symmetrieebene ausgeführt sind, wobei die Symmetrieebene senkrecht zu einer Leitungsrichtung der Verdrahtungselemente ausgeführt ist. Durch eine derartige Symmetrie wird der Scherkraft optimal entgegengewirkt, was sich positiv auf die Zuverlässigkeit der Halbleiteranordnung auswirkt.

Eine weitere Ausführungsform sieht vor, dass die Halbleiteranordnung eine Mehrzahl von Verdrahtungselementen umfasst, welche jeweils vom zweiten Leitungsabschnitt der ersten Substratmetallisierung über die Kontaktfläche mit der zweiten Substratmetallisierung des zweiten Substrats verbunden sind. Insbesondere für höhere Lastströme ist eine derartige Ausgestaltung vorteilhaft. Ferner werden durch eine Parallelschaltung von Verdrahtungselementen parasitäre Induktivitäten verringert, was zu geringeren Schaltverlusten führt, sodass eine verbesserte Zuverlässigkeit der Halbleiteranordnung erzielt wird.

Eine weitere Ausführungsform sieht vor, dass die Halbleiteranordnung ein zweites Halbleiterelement aufweist, das mit der ersten Substratmetallisierung des ersten Substrats verbunden ist und auf einer dem ersten Substrat abgewandten Seite eine Kontaktfläche aufweist, wobei die Kontaktfläche des zweiten Halbleiterelements über zumindest ein Verdrahtungselement mit der zweiten Substratmetallisierung des zweiten Substrats verbunden ist. Durch die Verbindung der Verdrahtungselemente des ersten Halbleiterelements und des zweiten Halbleiterelements mit einem gemeinsamen zweiten Substrat werden Fläche und somit Kosten eingespart.

Eine weitere Ausführungsform sieht vor, dass die Halbleiterelemente zumindest über einen, insbesondere identischen, Lastanschluss miteinander verbunden sind. Die Halbleiterelemente können beispielsweise parallelgeschaltet sein. Durch die Verbindung der Verdrahtungselemente der Halbleiterelemente mit einem gemeinsamen zweiten Substrat werden Fläche und somit Kosten eingespart.

Eine weitere Ausführungsform sieht vor, dass die zweite Substratmetallisierung des zweiten Substrats mindestens zwei elektrisch voneinander isolierte Leitungsabschnitte aufweist, wobei das zumindest eine Verdrahtungselement des ersten Halbleiterelements und das zumindest eine Verdrahtungselement des zweiten Halbleiterelements mit jeweils einem der elektrisch voneinander isolierten Leitungsabschnitte der zweiten Substratmetallisierung verbunden sind. Die Halbleiterelemente können beispielsweise antiseriell geschaltet sein. Durch die Verbindung der Verdrahtungselemente der Halbleiterelemente mit einem gemeinsamen zweiten Substrat werden Fläche und somit Kosten eingespart.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Halbleiteranordnung in einer Draufsicht,
- FIG 2: eine schematische Darstellung der ersten Ausführungsform der Halbleiteranordnung in einer Querschnittsdarstellung,
- FIG 3: eine schematische Darstellung einer zweiten Ausführungsform einer Halbleiteranordnung in einer Querschnittsdarstellung,
- FIG 4: eine schematische Darstellung einer dritten Ausführungsform einer Halbleiteranordnung in einer Draufsicht,
- FIG 5: eine schematische Darstellung einer vierten Ausführungsform einer Halbleiteranordnung in einer Draufsicht und
- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

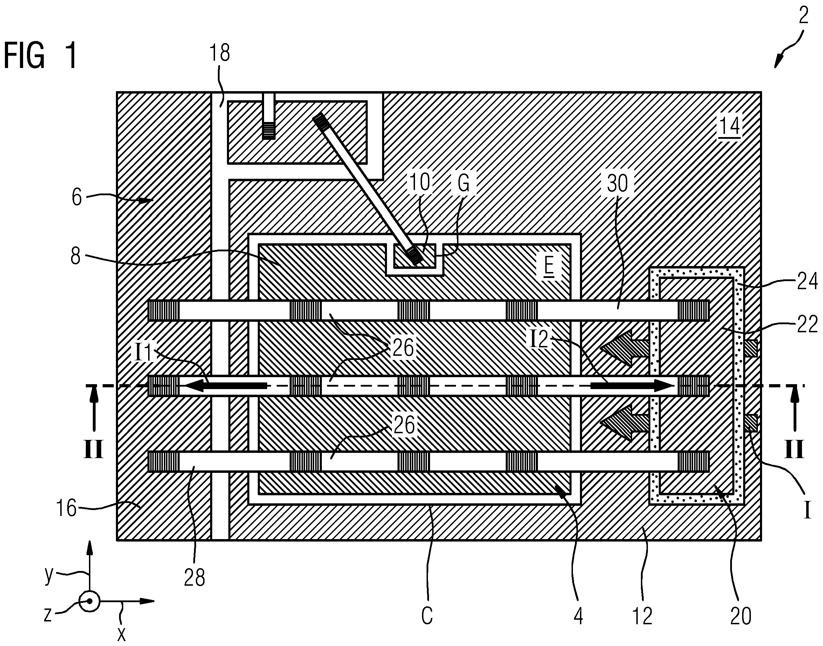

FIG 1 zeigt eine schematische Darstellung einer ersten Ausführungsform einer Halbleiteranordnung 2 in einer Draufsicht, welche ein erstes Halbleiterelement 4 umfasst, das auf einem ersten Substrat 6 kontaktiert ist. Beispielhaft ist das erste Halbleiterelement 4 als ein Insulated-Gate-BipolarTransistor (IGBT) ausgeführt. Weitere Beispiele für derartige Halbleiterelemente sind Triacs, Thyristoren, Dioden oder andere Transistortypen wie Feldeffekttransistoren oder Biploartransistoren. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind, wobei der Kollektor-Anschluss C, auf einer dem ersten Substrat 6 zugewandten Seite des ersten Halbleiterelements 4 stoffschlüssig, mit dem ersten Substrat 6 verbunden ist.

Der Emitter-Anschluss E weist eine Kontaktfläche 8 auf Die Kontaktfläche 8 und die Steuerkontaktfläche 10 weisen zumindest eine metallische Schicht auf, welche beispielsweise Aluminium, Kupfer und/oder Gold enthält. Der Kollektor-Anschluss C des IGBTs ist stoffschlüssig, beispielsweise über eine Löt- oder Sinterverbindung, mit einem ersten Leitungsabschnitt 12 einer ersten Substratmetallisierung 14 des ersten Substrats 6 verbunden. Ferner weist das erste Substrat 6 einen von dem ersten Leitungsabschnitt 12 elektrisch isoliert angeordneten zweiten Leitungsabschnitt 16. Darüber hinaus umfasst das erste Substrat 6 eine erste dielektrische Materiallage 18, die beispielsweise einen keramischen Werkstoff, insbesondere Aluminiumnitrid oder Aluminiumoxid, enthält. Das erste Substrat 6 kann unter anderem als ein DCB (Direct Copper Bonded) Substrat, ausgeführt sein.

Auf einer dem zweiten Leitungsabschnitt 16 gegenüberliegenden Seiten des ersten Halbleiterelements 4 ist ein zweites Substrat 20 stoffschlüssig, beispielsweise adhäsiv oder über eine Löt- oder Sinterverbindung, mit dem ersten Leitungsabschnitt 12 des ersten Substrats 6 verbunden. Das zweite Substrat 20 weist auf einer dem ersten Substrat 6 abgewandten Seite eine zweite Substratmetallisierung 22 auf, welche über eine zweite dielektrische Materiallage 24 elektrisch isoliert von dem ersten Leitungsabschnitt 12 der ersten Substratmetallisierung 14 angeordnet ist. Die zweite dielektrische Materiallage 24 kann unter anderem einen keramischen Werkstoff, insbesondere Aluminiumnitrid oder Aluminiumoxid, oder einen organischen Werkstoff, insbesondere ein Polymer, enthalten.

Überdies weist die Halbleiteranordnung 2 eine Mehrzahl von Verdrahtungselementen 26 zur Verbindung der Kontaktfläche 8 des Emitter-Anschlusses E mit dem zweiten Leitungsabschnitt 16 des ersten Substrats 6 und mit der zweiten Substratmetallisierung 22 des zweiten Substrats 20 auf. Das im Wesentlichen ebene Substrat 6 definiert eine xy-Ebene. Die Verdrahtungselemente 26 sind als im Wesentlichen parallel in x-Richtung verlaufende Bonddrähte oder Bondbänder, welche beispielsweise Aluminium, Kupfer und/oder Gold enthalten, ausgeführt. Beispielhaft sind die Verdrahtungselemente 26 geradlinig, insbesondere in x-Richtung verlaufend, angeordnet. Darüber hinaus weisen die Verdrahtungselemente 26 jeweils einen ersten Verbindungsabschnitt 28, welcher die Kontaktfläche 8 des Emitter-Anschlusses E mit dem zweiten Leitungsabschnitt 16 der ersten Substratmetallisierung 14 verbindet, und einen zweiten Verbindungsabschnitt 30, welcher die Kontaktfläche 8 des Emitter-Anschlusses E mit der zweiten Substratmetallisierung 22 des zweiten Substrats 20 verbindet, auf. Die mit dem zweiten Verbindungsabschnitt 30 des jeweiligen Verdrahtungselements 26 verbundene zweite Substratmetallisierung 22 ist aufgrund der zweiten dielektrischen Materiallage 24 leerlaufend ausgeführt. Die leerlaufende Anordnung hat zur Folge, dass während eines Betriebes der Halbleiteranordnung 2, ein erster Strom I1, insbesondere ein Laststrom, vom Emitter E über die ersten Verbindungsabschnitte 28 der jeweiligen Verdrahtungselementen 26 fließt, während ein, insbesondere vernachlässigbar kleiner, zweiter Strom I2 über die zweiten Verbindungsabschnitte 30 fließt. Insbesondere ist der erste Strom I1 um das Hundertfache, insbesondere um das Tausendfache größer als der zweite Strom 12. Somit weisen der erste Verbindungsabschnitt 28 und der zweite Verbindungsabschnitt 30 während des Betriebes der Halbleiteranordnung 2 einen unsymmetrischen Stromfluss auf.

Durch die zweite dielektrische Materiallage 24, welche die zweite Substratmetallisierung 22 des zweiten Substrats 20 von der ersten Substratmetallisierung 14 des ersten Substrats 6 elektrisch isoliert, kann im ersten Leitungsabschnitt 12 auch unterhalb des zweite Substrats 20 ein Strom I fließen. Somit wird die erste Substratmetallisierung 14 des ersten Substrats 6, insbesondere im Vergleich zu einer Bondinsel, in ihren elektrischen Eigenschaften nicht merklich beeinflusst. Der Strom I im ersten Leitungsabschnitt 12 des ersten Substrats 6 kann im Wesentlichen ungehindert bzw. unverändert zum Kollektor C des ersten Halbleiterelements 4 fließen.

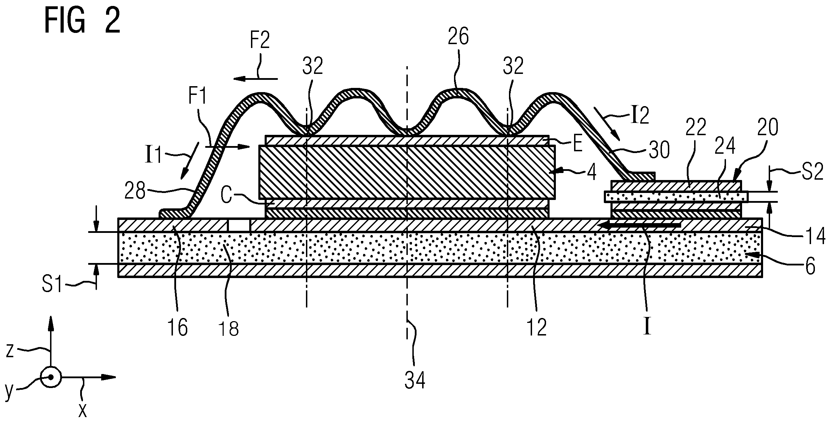

FIG 2 zeigt eine schematische Darstellung der ersten Ausführungsform der Halbleiteranordnung 2 in einer Querschnittsdarstellung. Die erste dielektrische Materiallage 18 des ersten Substrats 6 weist eine erste Stärke s1 von 25 µm bis 400 µm, insbesondere 50 µm bis 250 µm, auf, während die zweite dielektrische Materiallage 24 des zweiten Substrats 20 eine zweite Stärke s2 von 10 µm bis 250 µm, insbesondere 20 µm bis 150 µm, aufweist. Die Verdrahtungselemente 26 sind als Bonddrähte ausgeführt und bilden auf der Kontaktfläche 8 zwischen dem ersten Verbindungsabschnitt 28 und dem zweiten Verbindungsabschnitt 30 eine Mehrzahl von Verbindungen 32 aus, wobei die Verbindung mittels Ultraschall-Bonden hergestellt ist. Die Verbindung der Verdrahtungselemente 26 zur Kontaktfläche 8 des ersten Halbleiterelements 4 wird mittels Durchschleifen der Verdrahtungselemente 26, insbesondere mittels Multi-Stitch Wedge-to-Wedge-Wirebonding, hergestellt. Das mehrfache Bonden wird auch "Stitchen" genannt. Üblicherweise werden derartige Verbindungen 32 auch als "Stitchkontakte" bzw. "Stitchbonds" bezeichnet und können z.B. als "Wedgebonds" ausgeführt sein. Der erste Verbindungsabschnitt 28 und der zweite Verbindungsabschnitt 30 der jeweiligen Verdrahtungselemente 26 sind im Wesentlichen symmetrisch bezüglich einer Symmetrieebene 34 ausgeführt, wobei die Symmetrieebene 34 senkrecht zur Leitungsrichtung der in x-Richtung verlaufend angeordneten Verdrahtungselemente 26 ausgeführt ist.

Fließt ein erster Strom I1, insbesondere Laststrom, über die Verdrahtungselemente 26, wirkt eine Scherkraft F1 auf die Verbindungen 32, insbesondere Ultraschall-Bondverbindungen. Infolge des Überbondens der Verdrahtungselemente 26 über den zweiten Verbindungsabschnitt 30 auf das zweite Substrat 20 kann eine Gegenkraft F2 der Scherkraft F1 entgegenwirken, sodass die Verbindungen 32, insbesondere unter Last, robuster sind. Die Folge ist, dass durch das Überbonden eine längere Lebensdauer der Halbleiteranordnung 2 erzielt wird.

Das zweite Substrat 20 weist eine über die zweite dielektrische Materiallage 24 elektrisch von der zweiten Substratmetallisierung 22 angeordnete dritte Substratmetallisierung 36 auf. Über die dritte Substratmetallisierung 36 ist das zweite Substrat 20 mit der erste Substratmetallisierung 14 des ersten Substrats 6 stoffschlüssig verbunden. Alternativ kann auf die dritte Substratmetallisierung 36 verzichtet werden, wobei die stoffschlüssige Verbindung beispielsweise adhäsiv hergestellt wird. Insbesondere kann die zweite Substratmetallisierung 22 als ein Metallplättchen und die zweite dielektrische Materiallage 24 als elektrisch isolierende Klebeschicht ausgeführt sein, wobei das Metallplättchen über die elektrisch isolierende Klebeschicht mit dem ersten Substrat 6 verbunden ist. Über den ersten Leitungsabschnitt 12 der ersten Substratmetallisierung 14 des ersten Substrats 6 erfolgt unterhalb des zweite Substrats 20 ein durch das zweite Substrat 20 nicht merklich beeinflusster Strom I, insbesondere Laststrom, zum Kollektor C des ersten Halbleiterelements 4.

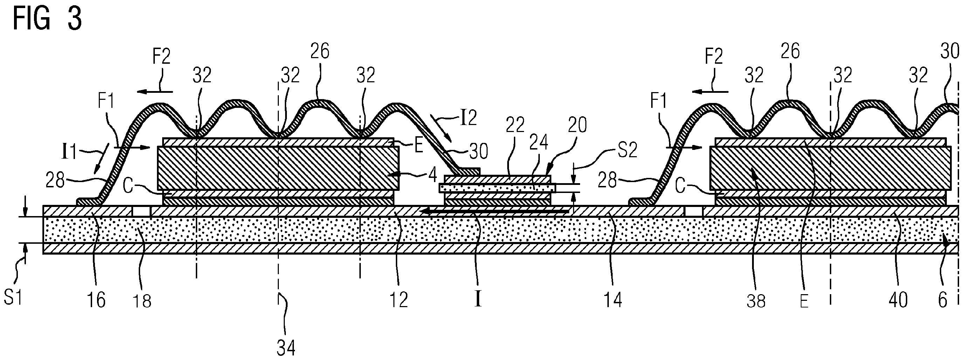

FIG 3 zeigt eine schematische Darstellung einer zweiten Ausführungsform einer Halbleiteranordnung 2 in einer Querschnittsdarstellung, wobei mit dem als IGBT ausgeführten ersten Halbleiterelement 4 und einem zweiten Halbleiterelement 38, das ebenfalls als IGBT ausgeführt ist, eine Halbbrücke ausbildet ist. Das zweite Halbleiterelement 38 ist, insbesondere stoffschlüssig, mit einem dritten Leitungsabschnitt 40 der ersten Substratmetallisierung 14 verbunden. Das erste Halbleiterelement 4 ist als Low Side Schalter und das zweite Halbleiterelement 38 als Low Side Schalter der Halbbrücke konfiguriert. Ein Strom I, insbesondere Laststrom, fließt unterhalb des zweite Substrats 20 vom Emitter E des als High Side Schalter ausgeführten zweiten Halbleiterelements 38 zum Kollektor C des als Low Side Schalter ausgeführten ersten Halbleiterelements 4. Beide Halbleiterelemente 4, 38 sind über die zweiten Verbindungsabschnitte 30 der jeweiligen Verdrahtungselemente 26 überbondet, was sich positiv auf die Lebensdauer der Halbleiteranordnung 2 auswirkt. Die weitere Ausführung der Halbleiteranordnung 2 in FIG 3 entspricht der in FIG 1 bzw. FIG 2.

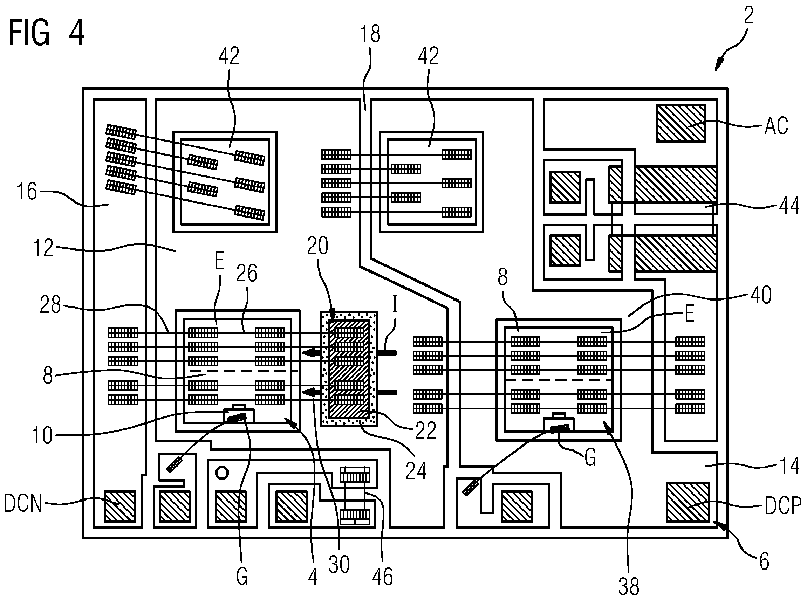

FIG 4 zeigt eine schematische Darstellung einer dritten Ausführungsform einer Halbleiteranordnung 2 in einer Draufsicht, wobei die Halbleiterelemente 4, 38 weisen jeweils eine antiparallel geschaltete Diode 42 aufweisen und, wie in FIG 3, eine Halbbrücke ausbilden. Der erster Leitungsabschnitt 12 des Substrats 6 ist über einen Shunt-Widerstand 44 mit einem AC-Anschluss AC verbunden, während der zweite Leitungsabschnitt 16 mit einem negativen DC-Anschluss DCN der Halbbrücke verbunden ist. Das zweite Halbleiterelement 38 ist stoffschlüssig mit dem dritten Leitungsabschnitt 40 der ersten Substratmetallisierung 14 verbunden, wobei der dritte Leitungsabschnitt 40 mit einem positiven DC-Anschluss DCP der Halbbrücke verbunden ist. Ferner umfasst die Halbleiteranordnung 2 einen Temperatursensor 46, der beispielsweise als ein NTC-Thermistor (Negative Temperature Coefficient Thermistor) ausgeführt ist. Ein Strom I, insbesondere Laststrom, fließt unterhalb des zweite Substrats 20 vom Emitter E des als High Side Schalter der Halbbrücke ausgeführten zweiten Halbleiterelements 38 zum Kollektor C des als Low Side Schalter der Halbbrücke ausgeführten ersten Halbleiterelements 4. Die weitere Ausgestaltung der Halbleiteranordnung 2 in FIG 4 entspricht der in FIG 3.

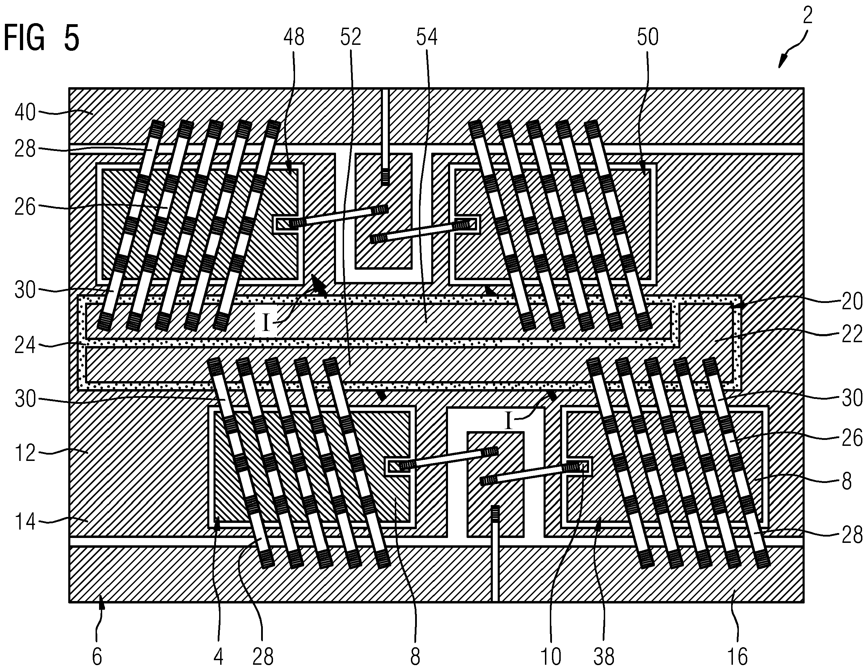

FIG 5 zeigt eine schematische Darstellung einer vierten Ausführungsform einer Halbleiteranordnung 2 in einer Draufsicht, welche beispielhaft vier Halbleiterelemente 4, 38, 48, 50 umfasst. Die Halbleiterelemente 4, 38, 48, 50 sind beispielhaft als vertikale Feldeffekttransistoren, insbesondere als vertikale SiC-MOSFETs, ausgeführt. Alternativ können die Halbleiterelemente 4, 38, 48, 50 unter anderem als IGBTs ausgeführt sein. Ein erstes und ein zweites Halbleiterelement 4, 38 sowie ein drittes und ein viertes Halbleiterelement 48, 50 sind jeweils paarweise parallelgeschaltet. Die paarweise parallelgeschalteten Halbleiterelemente 4, 38, 48, 50 sind stoffschlüssig mit dem ersten Leitungsabschnitt 12 der ersten Substratmetallisierung 14 des ersten Substrats 6 verbunden, sodass diese drain-seitig verbunden sind. Eine derartige antiserielle Verschaltung kann unter anderem in einem Vienna-Rectifier zum Einsatz kommen.

Die zweite Substratmetallisierung 22 des zweiten Substrats 20 ist strukturiert ausgeführt und weist zwei elektrisch voneinander isolierte Leitungsabschnitte 52, 54 auf. Die Verdrahtungselemente 26 der parallelgeschalteten ersten und zweiten Halbleiterelemente 4, 38 sind vom zweiten Leitungsabschnitt 16 des ersten Substrats 6 über die Kontaktflächen 8 der parallelgeschalteten Halbleiterelemente 4, 38 mit einem vierten Leitungsabschnitt 52 der zweiten Substratmetallisierung 22 des zweiten Substrats 20 verbunden. Ferner sind die Verdrahtungselemente 26 der parallelgeschalteten dritten und vierten Halbleiterelemente 48, 50 vom dritten Leitungsabschnitt 40 des ersten Substrats 6 über die Kontaktflächen 8 der parallelgeschalteten Halbleiterelemente 48, 50 mit einem fünften Leitungsabschnitt 54 der zweiten Substratmetallisierung 22 des zweiten Substrats 20 verbunden. Somit kann ein Strom I, insbesondere Laststrom, unterhalb des zweiten Substrats 20 zwischen den antiseriell verschalteten Halbleiterelementen 4, 38, 48, 50 fließen. Über das gemeinsame zweite Substrat 20 wird jeweils ein Potentialausgleich zwischen den paarweise parallelgeschalteten Halbleiterelementen 4, 38, 48, 50 erzielt. Die weitere Ausgestaltung der Halbleiteranordnung 2 in FIG 5 entspricht der in FIG 1 bzw. FIG 2.

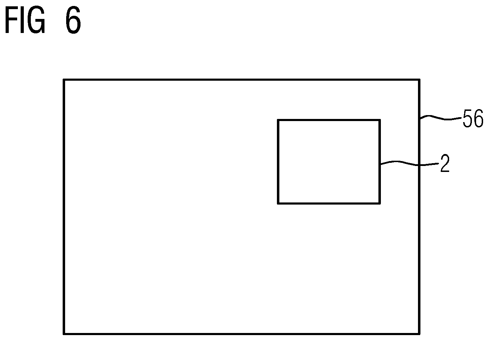

FIG 6 zeigt eine schematische Darstellung eines Stromrichters 56, welcher beispielhaft eine Halbleiteranordnung 2 umfasst

Zusammenfassend betrifft die Erfindung eine Halbleiteranordnung 2 mit einem ersten Halbleiterelement 4, einem ersten Substrat 6, einem zweiten Substrat 20 und zumindest einem Verdrahtungselement 26. Um eine verbesserte Zuverlässigkeit zu erreichen, wird vorgeschlagen, dass das erste Substrat 6 eine erste Substratmetallisierung 14 mit voneinander elektrisch isoliert angeordneten Leitungsabschnitten 12, 16 aufweist, wobei das erste Halbleiterelement 4 und das zweite Substrat 20, insbesondere stoffschlüssig, mit einem ersten Leitungsabschnitt 12 der ersten Substratmetallisierung 14 verbunden sind, wobei das zweite Substrat 20 auf einer dem ersten Substrat 6 abgewandten Seite eine zweite Substratmetallisierung 22 aufweist, welche über eine zweite dielektrische Materiallage 24 elektrisch isoliert vom ersten Leitungsabschnitt 12 der ersten Substratmetallisierung 14 angeordnet ist, wobei das erste Halbleiterelement 4 auf einer dem ersten Substrat 6 abgewandten Seite eine Kontaktfläche 8 aufweist, wobei die Kontaktfläche 8 mit zumindest einem Verdrahtungselement 26 verbunden ist, wobei das zumindest eine Verdrahtungselement 26 einen ersten Verbindungsabschnitt 28, welcher die Kontaktfläche 8 mit einem vom dem ersten Leitungsabschnitt 12 elektrisch isoliert angeordneten zweiten Leitungsabschnitt 16 der ersten Substratmetallisierung 14 verbindet, und einen zweiten Verbindungsabschnitt 30, welcher die Kontaktfläche 8 mit der zweiten Substratmetallisierung 22 des zweiten Substrats 20 verbindet, aufweist.

## Patentansprüche

1. Halbleiteranordnung (2) mit einem ersten Halbleiterelement (4), einem ersten Substrat (6), einem zweiten Substrat (20) und zumindest einem Verdrahtungselement (26), wobei das erste Substrat (6) eine erste Substratmetallisierung (14) mit voneinander elektrisch isoliert angeordneten Leitungsabschnitten (12, 16) aufweist,
wobei das erste Halbleiterelement (4) und das zweite Substrat (20), insbesondere stoffschlüssig, mit einem ersten Leitungsabschnitt (12) der ersten Substratmetallisierung (14) verbunden sind,
wobei das zweite Substrat (20) auf einer dem ersten Substrat (6) abgewandten Seite eine zweite Substratmetallisierung (22) aufweist,
welche über eine zweite dielektrische Materiallage (24) elektrisch isoliert vom ersten Leitungsabschnitt (12) der ersten Substratmetallisierung (14) angeordnet ist,
wobei das erste Halbleiterelement (4) auf einer dem ersten Substrat (6) abgewandten Seite eine Kontaktfläche (8) aufweist,
wobei die Kontaktfläche (8) mit zumindest einem Verdrahtungselement (26) verbunden ist,
wobei das zumindest eine Verdrahtungselement (26)
- einen ersten Verbindungsabschnitt (28), welcher die Kontaktfläche (8) mit einem vom dem ersten Leitungsabschnitt (12) elektrisch isoliert angeordneten zweiten Leitungsabschnitt (16) der ersten Substratmetallisierung (14) verbindet, und
- einen zweiten Verbindungsabschnitt (30), welcher die Kontaktfläche (8) mit der zweiten Substratmetallisierung (22) des zweiten Substrats (20) verbindet,
aufweist.

2. Halbleiteranordnung (2) nach Anspruch 1,
wobei das zweite Substrat (20) derartig auf dem ersten Leitungsabschnitt (12) des ersten Substrats (6) angeordnet ist, dass während eines Betriebes der Halbleiteranordnung (2) ein Strom (I) im ersten Leitungsabschnitt (12) des ersten Substrats (6) zumindest teilweise unterhalb des zweiten Substrats (20) fließt.

3. Halbleiteranordnung (2) nach Anspruch 2,
wobei der unterhalb des zweiten Substrats (20) fließende Strom (I) ein Laststrom des ersten Halbleiterelements (4) ist.

4. Halbleiteranordnung (2) nach einem der Ansprüche 1 bis 3, wobei das zweite Substrat (20) flächig auf dem ersten Leitungsabschnitt (12) der ersten Substratmetallisierung (14) aufliegt.

5. Halbleiteranordnung (2) nach einem der vorherigen Ansprüche,
wobei sich die erste dielektrische Materiallage (18) des ersten Substrats (6) von der zweiten dielektrischen Materiallage (24) des zweiten Substrats (20), insbesondere hinsichtlich ihrer elektrischen Isolation und/oder thermischen Leitfähigkeit, unterscheidet.

6. Halbleiteranordnung (2) nach einem der vorherigen Ansprüche,
wobei die erste dielektrische Materiallage (18) des ersten Substrats (6) eine erste Stärke (s1) und die zweite dielektrische Materiallage (24) des zweiten Substrats (20) eine zweite Stärke (s2) aufweist,
wobei die zweite Stärke (s2) kleiner als die erste Stärke ist.

7. Halbleiteranordnung (2) nach einem der vorherigen Ansprüche,
wobei die zweite Substratmetallisierung (22) des zweiten Substrats (20) leerlaufend angeordnet ist.

8. Halbleiteranordnung (2) nach einem der vorherigen Ansprüche,
wobei der erste Verbindungsabschnitt (28) und der zweite Verbindungsabschnitt (30) des jeweiligen Verdrahtungselements (26) im Wesentlichen symmetrisch bezüglich einer Symmetrieebene (34) ausgeführt sind,
wobei die Symmetrieebene 34 senkrecht zu einer Leitungsrichtung der Verdrahtungselemente 26 ausgeführt ist.

9. Halbleiteranordnung (2) nach einem der vorherigen Ansprüche,
wobei die Halbleiteranordnung (2) eine Mehrzahl von Verdrahtungselementen (26) umfasst, welche jeweils vom zweiten Leitungsabschnitt (16) der ersten Substratmetallisierung (14) über die Kontaktfläche (8) mit der zweiten Substratmetallisierung (22) des zweiten Substrats (20) verbunden sind.

10. Halbleiteranordnung (2) nach einem der vorherigen Ansprüche,
welche ein weiteres Halbleiterelement (38, 48, 50) aufweist, das mit der ersten Substratmetallisierung (14) des ersten Substrats (6) verbunden ist und auf einer dem ersten Substrat (6) abgewandten Seite eine Kontaktfläche (8) aufweist, wobei die Kontaktfläche (8) des zweiten Halbleiterelements (38) über zumindest ein Verdrahtungselement (26) mit der zweiten Substratmetallisierung (22) des zweiten Substrats (20) verbunden ist.

11. Halbleiteranordnung (2) nach Anspruch 10,
wobei die Halbleiterelemente (4, 38, 48, 50) zumindest über einen, insbesondere identischen, Lastanschluss miteinander verbunden sind.

12. Halbleiteranordnung (2) nach einem der Ansprüche 10 oder 11,
wobei die zweite Substratmetallisierung (22) des zweiten Substrats (20) mindestens zwei elektrisch voneinander isolierte Leitungsabschnitte (52, 54) aufweist,
wobei das zumindest eine Verdrahtungselement (26) des ersten Halbleiterelements (4) und das zumindest eine Verdrahtungselement (26) des zweiten Halbleiterelements (38) mit jeweils einem der elektrisch voneinander isolierten Leitungsabschnitte (52, 54) der zweiten Substratmetallisierung (22) verbunden sind.

13. Stromrichter (56) mit mindestens einer Halbleiteranordnung (2) nach einem der vorherigen Ansprüche.

14. Verfahren zur Herstellung einer Halbleiteranordnung (2) mit einem ersten Halbleiterelement (4), einem ersten Substrat (6), einem zweiten Substrat (20) und zumindest einem Verdrahtungselement (26),
wobei das erste Substrat (6) eine erste Substratmetallisierung (14) mit voneinander elektrisch isoliert angeordneten Leitungsabschnitten (12, 16) aufweist,
wobei das erste Halbleiterelement (4) und das zweite Substrat (20), insbesondere stoffschlüssig, mit einem ersten Leitungsabschnitt (12) der ersten Substratmetallisierung (14) verbunden werden,
wobei das zweite Substrat (20) auf einer dem ersten Substrat (6) abgewandten Seite eine zweite Substratmetallisierung (22) aufweist,
welche über eine zweite dielektrische Materiallage (24) elektrisch isoliert vom ersten Leitungsabschnitt (12) der ersten Substratmetallisierung (14) angeordnet ist,
wobei das erste Halbleiterelement (4) auf einer dem ersten Substrat (6) abgewandten Seite eine Kontaktfläche (8) aufweist,
wobei die Kontaktfläche (8) mit zumindest einem Verdrahtungselement (26) verbunden wird,
wobei das zumindest eine Verdrahtungselement (26)
- einen ersten Verbindungsabschnitt (28) aufweist, über welchen die Kontaktfläche (8) mit einem vom dem ersten Leitungsabschnitt (12) elektrisch isoliert angeordneten zweiten Leitungsabschnitt (16) der ersten Substratmetallisierung (14) verbunden wird und
- einen zweiten Verbindungsabschnitt (30) aufweist, über welchen die Kontaktfläche (8) mit der zweiten Substratmetallisierung (22) des zweiten Substrats (20) verbunden wird.

15. Verfahren nach Anspruch 14,
wobei das zweite Substrat (20) derartig auf dem ersten Leitungsabschnitt (12) des ersten Substrats (6) angeordnet wird, dass während eines Betriebes der Halbleiteranordnung (2) ein Strom (I), insbesondere ein Laststrom des ersten Halbleiterelements (4), im ersten Leitungsabschnitt (12) des ersten Substrats (6) zumindest teilweise unterhalb des zweiten Substrats (20) fließt.
